## Europäisches Patentamt
## European Patent Office
## Office européen des brevets

(19)

(11) Numéro de publication: **0 206 888**
**B1**

(12)

# FASCICULE DE BREVET EUROPEEN

(45) Date de publication du fascicule du brevet:
06.09.89

(51) Int. Cl.⁴: **H 03 H 9/05, G 01 L 9/08**

(21) Numéro de dépôt: 86401206.7

(22) Date de dépôt: 05.06.86

(54) Résonateur piézo-électrique à extremum de sensibilité vis à vis des contraintes extérieures de pression.

(30) Priorité: 14.06.85 FR 8509058

(43) Date de publication de la demande:
30.12.86 Bulletin 86/52

(45) Mention de la délivrance du brevet:
06.09.89 Bulletin 89/36

(84) Etats contractants désignés:
CH DE GB LI NL

(56) Documents cités:
US-A- 2 481 806
US-A- 4 439 705

IBM TECHNICAL DISCLOSURE BULLETIN, vol. 10, no. 4,
septembre 1967, pages 365,366, New York, US; R.A.
WATSON: "Force sensor crystal mounting"
INSTRUMENTS AND EXPERIMENTAL TECHNIQUES,
vol. 24, no. 6, partie 2, novembre-décembre 1981, pages
1524-1526, Plenum Publishing Corp., New York, US; A.G.
SMAGIN: "Sensitive frequency detector for pressures
to 600 Pa"

(73) Titulaire: ETAT-FRANCAIS représenté par le DELEGUE
GENERAL POUR L'ARMEMENT (DPAG), Bureau des
Brevets et Inventions de la Délégation Générale pour
l'Armement 26, Boulevard Victor, F-75996 Paris Armées
(FR)

(72) Inventeur: Delaite, Richard, 49 bis, 3 Faubourg de
Montbéliard, F-9000 Belfort (FR)

## Description

La présente invention a pour objet résonateur piézoélectrique à extremum de sensibilité vis à vis des contraintes extérieurs de pression, comprenant un cristal piézoélectrique constitué par une plaquette circulaire présentant au moins une face sphérique, des première et deuxième électrodes coopérant chacune avec une face du cristal appliqués sur la périphérie de celui-ci.

On connaît divers exemples de résonateurs piézoélectriques du type susmentionné.

Selon un premier exemple classique, un cristal résonateur est constitué par une plaquette du quartz plan-convexe ou bi-convexe à contour circulaire, sur les faces frontales de laquelle sont déposées directement des électrodes métalliques, dites électrodes adhérentes.

Selon un autre exemple de réalisation, la plaquette de quartz à électrodes adhérentes est limitée extérieurement par une couronne en quartz serrant au support du cristal-résonateur.

Selon encore un autre exemple de réalisation, le cristal-résonateur est relié à une couronne en quartz par des ponts taillés dans la masse. Les électrodes peuvent être adhérentes ou non adhérentes. Dans ce dernier cas, les électrodes sont déposés sur des plaquettes de quartz de même coupe que le cristal et de forme similaire et seules les couronnes des plaquettes-support d'électrodes sont en contact avec la couronne du cristal vibrant.

Dans ces divers exemples de résonateurs, on cherche généralement à minimiser l'influence de toutes les actions extérieures de pression exercées sur le cristal-résonateur, afin de réaliser une base de temps présentant une fréquence très stable.

Pour des applications des résonateurs en tant que capteurs de pression hydrostatique, on cherche cependant au contraire à augmenter la sensibilité du résonateur aux contraintes extérieures de pression, voir par exemple l'article de A. G. Smagin: «Sensitive frequency detector for pressures to 600 Pa.» publié dans INSTRUMENTS AND EXPERIMENTAL TECHNIQUES, vol. 24, no. 6, partie 2, novembre-décembre 1981, pages 1524–1526.

Dans un cas comme dans l'autre les systèmes existants ne permettent pas de réaliser de façon simple, un résonateur permettant un optimum de sensibilité vis à vis des contraintes extérieures de pression.

La présente invention vise précisément à réaliser un résonateur piézoélectrique dont la structure est simple et propre à conférer au résonateur un extremum de sensibilité vis à vis des contraintes extérieures de pression.

Ce but est atteint grâce à un résonateur piézoélectrique du type défini en tête de la description qui, conformément à l'invention, comprend des moyens pour exercer des efforts de compression ou de traction radiale délocalisée de façon uniformément répartie sur des zones du pourtour du cristal diamétralement opposées présentant une ouverture angulaire $2\alpha$ prédéterminée au moins égale à environ 110°, et situées de telle manière que les bissectrices desdites zones de pourtour forment un angle $\psi$ prédéterminé voisin de 0° ou de 90° par rapport au repère cristallographique X du cristal.

Selon un premier mode de réalisation, lesdits moyens pour exercer des efforts sur des zones du pourtour du cristal comprennent une bague circulaire en un matériau piézoélectrique présentant la même coupe et la même orientation que le cristal vibrant, qui est ajustée et serrée radialement contre la tranche du cristal dans des zones s'étendant selon des secteurs angulaires définis par lesdites zones de pourtour du cristal diamétralement opposées, et ladite bague circulaire comprend des parties intermédiaires radialement en retrait par rapport à la tranche du cristal qui sont situées entre lesdites zones de serage radial.

Selon un autre mode de réalisation, lesdits moyens pour exercer des efforts sur des zones du pourtour du cristal comprennent des première et deuxième bagues circulaires en un matériau piézoélectrique présentant la même coupe et la même orientation que le cristal vibrant, qui sont placées symétriquement de part et d'autre du cristal vibrant sur des zones circulaires et périphériques des faces du cristal et sont en contact avec le cristal au niveau desdites zones de pourtout du cristal diamétralement opposées, lesdites bagues présentent des parties intermédiaires axialement en retrait par rapport aux faces du cristal dans des zones intermédiaires entre lesdites zones de pourtour du cristal et lesdites bagues sont ajustées et serrées axialement contre les faces du cristal au niveau desdites zones de pourtour du cristal.

Par ailleurs, selon une caractéristique particulière de l'invention, dans le cas d'électrodes adhérentes au cristal sur la partie centrale des faces frontales de celui-ci, il est avantageux que les électrodes s'étendent chacune sur deux zones angulaires diamétralement opposées présentant une ouverture angulaire $2\alpha$ prédéterminée au moins égale à environ 110° et située de telle sorte que les bissectrices desdites zones angulaires forment un angle $\psi$ prédéterminé voisin de 0° ou de 90° par rapport au repère cristallographique X du cristal.

Selon un exemple de réalisation, visant à minimiser la sensibilité du résonateur vis à vis des contraintes extérieures, le résonateur comprend un cristal de quartz de coupe AT placé à température ambiante, les bissectrices (A–A) desdites zones de pourtout forment un angle $\psi$ de 90° par rapport au repère cristallographique X du cristal et l'ouverture angulaire $2\alpha$ prédéterminée desdites zones de pourtour est de l'ordre de 120°.

Selon un autre exemple de réalisation, visant également à minimiser la sensibilité du résonateur vis à vis des contraintes extérieures, le résonateur comprend un cristal de quartz de coupe AT placé à sa température d'inversion, les bissectrices (A–A) desdites zones de pourtour forment un angle $\psi$ de 90° par rapport au repère cristallographique X du cristal et l'ouverture angulaire $2\alpha$

prédéterminée desdites zones de pourtour est de 142°.

Selon un exemple de résonateur conforme à l'invention, adapté pour présenter une sensibilité maximum vis à vis des contraintes extérieures, le résonateur comprend un cristal de quartz de coupe AT placé à température ambiante, les bissectrices (A–A) desdites zones de pourtour forment un angle $\psi$ de 0° par rapport au repère cristallographique X du cristal et l'ouverture angulaire $2\alpha$ prédéterminée desdites zones de pourtour est de 114°.

D'autres caractéristiques et avantages de la présente invention ressortiront de la description suivante de modes particuliers de réalisation de l'invention donnés à titre d'exemples, en référence aux dessins annexés, sur lesquels:

– la figure 1 est une vue en plan montrant le principe d'un résonateur selon l'invention,

– la figure 2 est une vue en coupe selon le plan II–II de la figure 1,

– les figures 3 et 4 sont des vues en perspective montrant deux modes de réalisation différents d'un résonateur à compression orientée selon l'invention,

– la figure 5 est une vue en plan d'un exemple de mise en œuvre du mode de réalisation de la figure 3,

– la figure 6 est une coupe selon le plan VI–VI de la figure 5, présentée en vue éclatée,

– la figure 7 est une vue en plan d'un exemple de mise en œuvre du mode de réalisation de la figure 4,

– la figure 8 est une coupe selon le plan VIII–VIII de la figure 7, présentée en vue éclatée,

– les figures 9 à 12 représentent différentes vues en plan analogues à la figure 1 et correspondant à des configuration optimale minimisant la sensibilité du résonateur aux contraintes extérieures,

– la figure 13 est une vue en plan d'un résonateur muni d'électrodes adhérentes présentant une configuration spécifique selon une caractéristique de la présente invention,

– la figure 14 est une vue en élévation du résonateur de la figure 13,

– la figure 15 représente des courbes montrant l'évolution de l'orientation $\psi$ de la compression radiale exercée sur le résonateur en fonction de l'ouverture angulaire $2\alpha$ de cette compression radiale, pour un cristal de quartz de coupe AT respectivement à une température de 25° C (courbe en pointillés) et à la température d'inversion du cristal (courbe en trait plein), de manière à définir un résonateur dont les variations de fréquence sont nulles quelles que soient les variations de la compression uniformément répartie sur une zone diamétral du pourtour du cristal,

– la figure 16 représente deux courbes donnant la sensibilité d'un cristal de quartz de coupe AT à une température de 25° C en fonction de l'orientation $\psi$ de la compression radiale exercée sur le résonateur d'une part pour une ouverture angulaire $2\alpha$ nulle et d'autre part une ouverture angulaire $2\alpha$ égale à 121°, et

– la figure 17 représente la coubre donnant la sensibilité du résonateur en fonction de l'ouverture angulaire $2\alpha$ de la compression radiale exercée sur le résonateur pour un crisal de quartz de coupe AT à la température de 25° C.

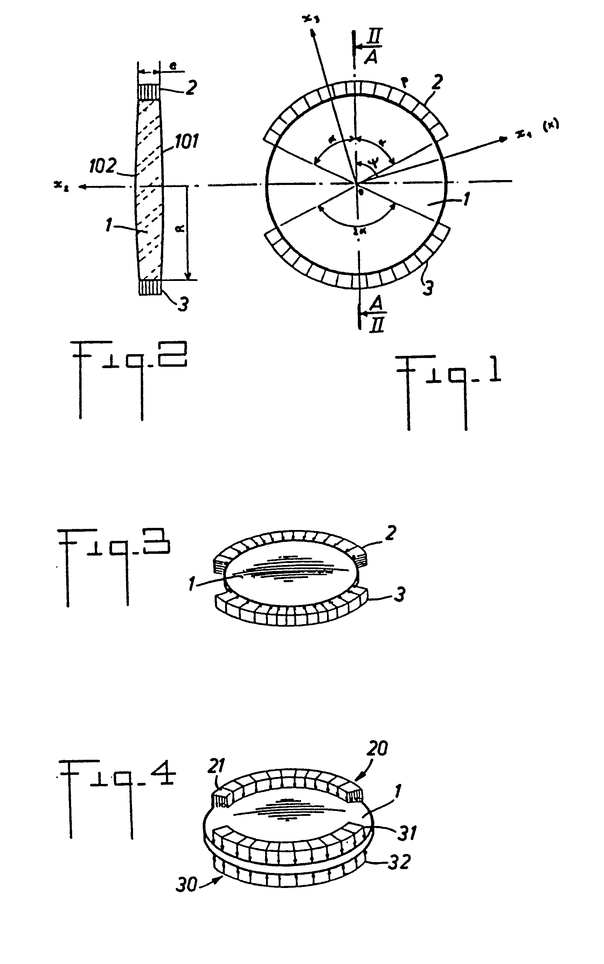

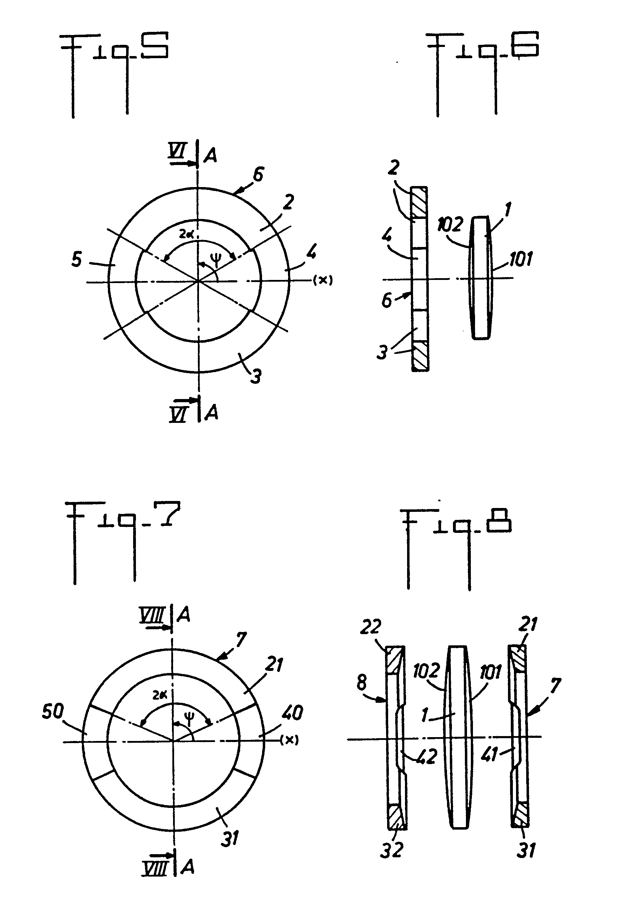

On a représenté sur les figures 1 et 2 un cristal-résonateur 1 en quartz avec ses axes cristallographiques $x_1$, $x_2$, $x_3$, les axes $x_1$ (X) et $x_3$ étant situés dans le plan de la figure 1 et l'axe $x_2$ étant perpendiculaire au plan de la figure 1. Le cristal 1 est limité par un contour circulaire de rayon R et présente à sa périphérie une épaisseur e. Les faces frontales 101, 102 sont sphériques pour permettre l'utilisation du principe du piégeage de l'énergie au centre du cristal. On notera cependant que le cristal 1 ne doit pas nécessairement être biconvexe. Il suffit en effet qu'au moins l'une des faces 101, 102 soit sphérique.

Le cristal 1 coopère avec deux électrodes, non représentées sur les figures 1 et 2, qui sont situées en regard de la partie centrale active des faces frontales 101, 102. Les électrodes peuvent être adhérentes au cristal 1 ou non adhérentes et portées par des plateaux disposés de part et d'autre du cristal 1. Dans l'un ou l'autre cas, le cristal-résonateur 1 vibre en cisaillement d'épaisseur.

D'une manière générale, la fréquence de vibration du cristal-résonateur 1 est perturbée sous l'action des contraintes extérieures exercées sur le cristal.

Pour remédier à cet inconvénient et disposer d'un cristal-résonateur maintenu de telle manière que l'on puisse contrôler l'influence des contraintes extérieures de pression sur la fréquence, pour en particulier obtenir une influence nulle ou au contraire une influence maximum, conformément à l'invention, on exerce globalement par des moyens 2, 3 une compression p ou une extension radiale uniformément répartie sur deux zones limitées diamétralement opposées du pourtour du cristal qui présentent une ouverture angulaire $2\alpha$ prédéterminée et sont orientées par rapport au cristal 1, les bissectrices A–A des deux zones de compression ou d'extension formant un angle $\psi$ prédéterminé par rapport au repère cristallographique X du cristal de quartz (fig. 1).

On crée ainsi au centre du cristal un état de contraintes qui, suivant le choix des angles $2\alpha$ et $\psi$, est caractérisé soit par une influence nulle, soit par une influence maximale des contraintes extérieures sur la fréquence du résonateur, selon qu'il s'agit d'appliquer le résonateur à la constitution d'une base de temps ou au contraire de faire jouer au résonateur le rôle de capteur d'effort.

Les valeurs de l'angle d'orientation $\psi$ et de l'ouverture angulaire $2\alpha$ des zones de compression ou d'extension radiale répartie doivent être adaptées en fonction des caractéristiques suivantes:

– La nature et les performances du quartz utilisé pour le cristal-résonateur.

– La coupe du cristal avec la valeur des angles correspondant à une simple ou une double rotation.

– La température de fonctionnement, qui est en général celle du point d'inversion de la courbe fréquence–température.

A titre d'exemple, on considérera ci-dessous le cas d'un cristal de quartz de coupe AT.

$$\frac{\overline{f}_k - f_k}{f_K} = \frac{-F}{2c_{66}\, 2h_o \pi\, R}\; \left\{2(k_3 - k_1)\; \frac{\sin 2\alpha}{2\alpha}\cos 2\psi - (k_1 + k_3)\right\} \quad (1)$$

où $c_{66}$ représente un coefficient élastique du premier ordre pour le quartz,

$k_1$ et $k_3$ représentent des coefficients prenant en compte les coefficients élastiques et de souplesse de $2^{ème}$ et $3^{ème}$ ordres pour le quartz,

$2h_o$ représente l'épaisseur du cristal, R représente le rayon du cristal,

$2\alpha$ représente l'ouverture angulaire des zones de contrainte diamétralement opposées à la périphérie du cristal, $\psi$ représente l'angle formé par les bissectrices des zones de contrainte diamétralement opposées par rapport à l'axe X du cristal,

$F = 2\alpha\, 2h_o\, R_p$

p étant la pression exercée à la périphérie du cristal.

Pour une température de 25° C, on a les valeurs numériques suivantes:

$k_1 = 0{,}957$

$k_3 = 0{,}103$

$1/(2.c_{66}) = 1{,}722.10^{-11}\ N^{-1}m^2$

A partir de la relation (1), on peut introduire un coefficient de sensibilité $Q_F$ du résonateur aux variations de contraintes extérieures, selon la relation (2) suivante:

$$Q_F = 2(k_3 - k_1)\; \frac{\sin 2\alpha}{2\alpha}\cos 2\psi - (k_1 + k_3) \quad (2)$$

En pratique, on sait que les forces de maintien F du cristal évoluent au cours du temps et ne permettent donc pas d'obtenir un état de contrainte stable au centre du cristal. Les phénomène liés, notamment, aux relaxations de contraintes dans la structure de maintien ainsi que ceux liés aux dilatations différentielles entre les différents éléments en sont la cause. Même s'il est possible d'augmenter la stabilité des efforts de maintien du cristal résonateur, il n'est pas envisageable d'obtenir une très haute stabilité en maintenant la force F et le coefficient de sensibilité $Q_F$ constants, ni même en maintenant le produit $F.Q_F$ constant.

Selon l'invention, on choisit donc des valeurs de l'angle d'orientation $\psi$ et de l'ouverture angulaire $2\alpha$ qui sont telles que le coefficient de sensibilité $Q_F$ soit nul dans les conditions de fonctionnement envisagées.

Cette condition de valeur nulle pour le coefficient $Q_F$ est réalisé lorsque:

$$\psi = 1/2\ \cos^{-2}\,(K\ 2\alpha/\sin 2\alpha) \quad (3)$$

avec

$$K = k_1 + k_3 / 2(k_3 - k_1) \quad (4)$$

où $\psi$, $2\alpha$, $k_1$ et $k_3$ ont les significations indiquées en référence aux équations (1) et (2).

Dans ce cas, on a établi que la variation relative de fréquence d'un cristal subissant des contraintes extérieures à sa périphérie peut s'exprimer selon l'équation (1) ci-dessous:

Lorsque l'égalité (3) est réalisée, la variation de fréquence est nulle, quelles que soient les variations de la compression uniformément répartie sur une zone diamétrale du pourtour du cristal.

Les valeurs du module de $\psi$ en fonction du secteur angulaire $2\alpha$ correspondant à cette condition sont données par la courbe en pointillés 201 de la figure 15 pour un cristal de coupe AT à la température de 25° C et par la courbe en traits pleins 202 de la figure 15 pour le même cristal placé à sa température d'inversion $T_i$ qui en l'espèce correspond à 78° C. La valeur du coefficient K varie en effet en fonction de la température.

On a représenté sur les figures 9 à 12 plusieurs possibilités de positionnement et d'étendue des moyens 2,3 produisant à la périphérie du cristal des zones de compression réparties telles que la valeur du coefficient de sensibilité $Q_F$ soit nulle. Les figures 9 à 12 montrent ainsi quatre exemples de couples de valeurs $\psi$, $2\alpha$ déduits de la courbe 201 de la figure 15.

Sur la figure 9, on voit le cas d'un cristal comprimé par deux forces localisées diamétralement opposées ($2\alpha = 0$) orientées selon une direction qui fait un angle $\psi$ de 56,9° par rapport à l'axe cristallographique $x_1$. On notera que dans un tel cas, le positionnement des moyens 2,3 exerçant un effort sur le cristal doit être très précis pour que la condition $Q_F = 0$ soit réalisée, ce qui rend le montage délicat.

Sur la figure 10, l'angle $\psi$ définissant l'orientation des efforts par rapport à l'axe cristallographique $x_1$ est de 57°, ce qui implique que l'effort radial soit réparti uniformément sur un secteur angulaire $2\alpha = 10°$ de part et d'autre d'une droite faisant l'angle $\psi$ avec l'axe $x_1$. Là encore, la précision du montage doit être très grande et un tel cas ne peut être considéré comme satisfaisant en pratique.

La figure 11 montre une possibilité qui pourrait être acceptable en pratique dans la mesure où l'ouverture $2\alpha$ du secteur angulaire sur lequel sont répartis les efforts exercés uniformément à la périphérie du cristal vaut 90°, avec une orientation par rapport à l'axe cristallographique $x_1$ définie par un angle $\psi = 65°$.

La figure 12 représente un cas optimum pour lequel la sensibilité du résonateur aux efforts extérieurs est la plus limitée. Ce cas correspond à une orientation définie par un angle $\psi$ de 90° et implique une ouverture angulaire $2\alpha = 121°$.

On notera que les grandes valeurs du secteur angulaire $2\alpha$ permettent de réduire la sensibilité du cristal-résonateur 1 aux efforts qui lui sont appliqués. On a donc intérêt en pratique à choisir une valeur de secteur angulaire $2\alpha$ suffisamment importante, par exemple supérieure à environ 110°, et à positionner les moyens 2, 3 de répartition d'efforts de compression ou d'extension radiale à la périphérie du cristal de telle manière que les bissectrices des secteurs angulaires diamétralement opposés fassent avec l'axe $x_1$ un angle $\psi$ tel que la relation (3) soit satisfaite.

La figure 16 permet de comparer les courbes de sensibilité $Q_F$ en fonction de la valeur de l'angle $\psi$ pour les cas $2\alpha = 0$ (courbe 203) et $2\alpha = 121°$ (courbe 204) pour un cristal de quartz de coupe AT à la température de 25° C.

On peut remarquer que la valeur maximale du $2\alpha$ permet d'obtenir un coefficient $Q_F$ à pente nulle au point $\psi = \pi/2$, ce qui correspond au cas de la figure 12, qui vise à minimiser l'influence des efforts extérieurs sur la fréquence du cristal résonateur 1.

Une configuration telle que celle de la figure 12 permet ainsi de supprimer l'influence des défauts de fabrication et de réduire au maximum l'influence accélérométrique tout en augmentant la résistance aux chocs. Un léger défaut de positionnement des moyens de compression radiale 2,3 par rapport à la valeur optimale $\psi = \pi/2$ n'est dans ce cas pas gênant, contrairement au cas des figures 9 et 10 ou, dans une moindre mesure, à celui de la figure 11.

Si l'on considère la courbe 202 de la figure 15, on peut observer que la position limite optimale pour minimiser l'influence des efforts extérieurs sur la fréquence du cristal est toujours $\psi = \pi/2$. Toutefois, compte tenue de la température plus élevée qui correspond à la température d'inversion du cristal, la valeur maximale de secteur angulaire de compression $2\alpha$ correspondant à l'angle $\psi = \pi/2$ devient égale à 142°.

Selon une autre application de l'invention, selon laquelle on utilise le cristal-résonateur en tant que capteur pour des mesures de pression, on souhaite maximaliser la valeur du coefficient de sensibilité $Q_F$.

Pour une pression hydrostatique uniforme p appliquée sur un secteur angulaire $2\alpha$ du cristal, la variation de fréquence maximale est donnée par la relation (1) pour la position $\psi = 0$.

Dans ce cas la relation (1) devient:

$$\frac{\overline{f}_k - f_k}{f_k} = \frac{-p}{2c_{66}\,\pi}\,2\alpha\,\left\{2(k_3 - k_1)\,\frac{\sin 2\alpha}{2\alpha} - (k_1 + k_3)\right\} \qquad (5)$$

Comme représenté sur la courbe 205 de la figure 17, le maximum de sensibilité est obtenu pour le secteur angulaire $2\alpha$ tel que le produit $2\alpha Q_F$ prenne une valeur maximale.

Pour le cas de la courbe de la figure 17 qui correspond à un cristal de quartz de coupe AT placé à 25° C, avec un angle $\psi = 0$, la valeur $2\alpha_0$ vaut 114°.

Comme dans le cas d'une recherche d'un coefficient de sensibilité $Q_F$ nul, il convient donc de choisir des valeurs $2\alpha$ d'ouverture angulaire importantes, mais pour la recherche d'un maximum de sensibilité, l'angle $\psi$ doit alors être voisin de 0 et non de $\pi/2$.

Pour obtenir un extremum (c'est-à-dire un minimum ou un maximum) de sensibilité du résonateur piézoélectrique vis à vis des contraintes extérieures de pression, il convient donc d'exercer un compression, ou d'une façon équivalente une traction, radiale, qui est uniformément répartie sur des zones limitées mais substantielles de la périphérie du cristal et qui est orientée par rapport au repère cristallographique du cristal.

La compression radiale est obtenue, selon l'intervention, grâce à des répartiteurs de pression constitués par des bagues circulaires en quartz munies de dégagements correspondant aux zones de non compression.

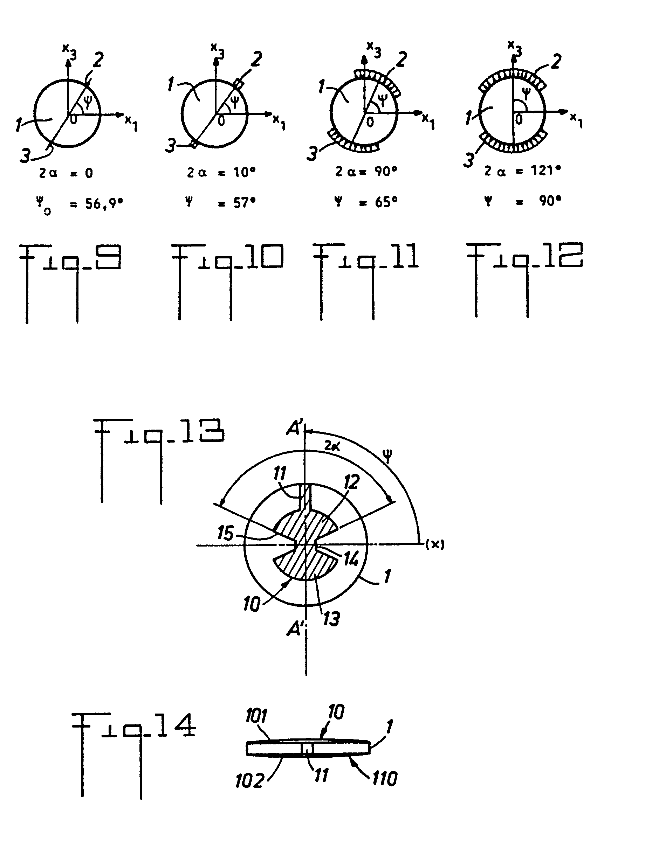

Les figures 3 et 5, 6 concernent un premier mode de réalisation dans lequel la compression exercée radialement est appliquée directement sur la tranche du cristal résonateur 1, par des moyens de compression 2, 3 situé dans le plan du cristal 1.

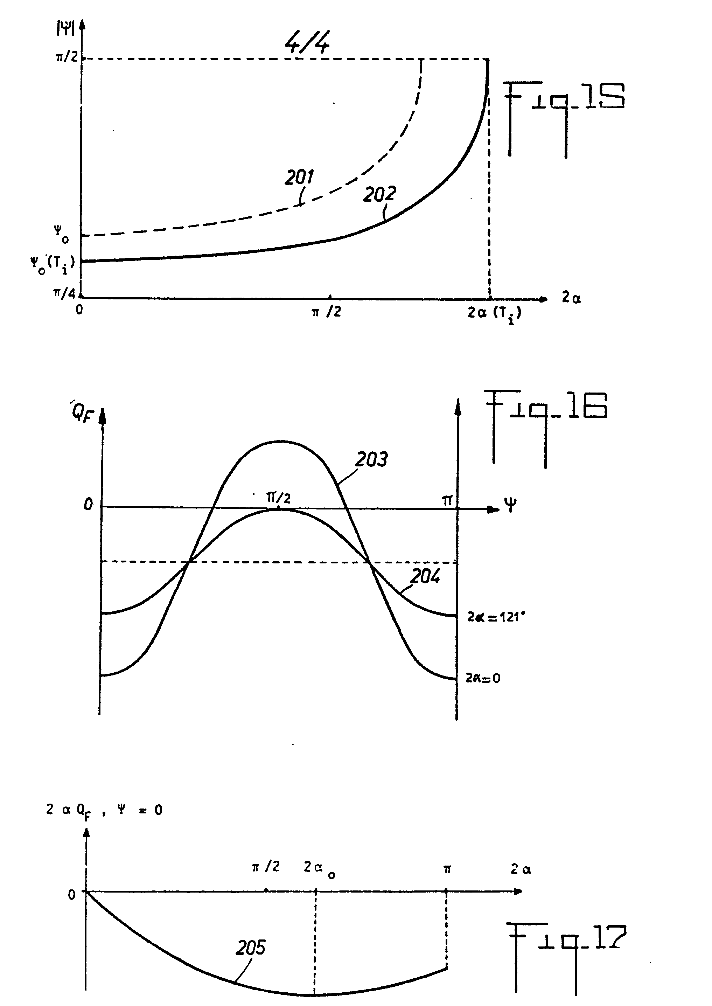

Un exemple de répartiteur de pression 6 correspondant au schéma de principe de la figure 3 est représenté sur les figures 5 et 6.

Le répartiteur de pression 6 est constitué par une bague en quartz ayant la même coupe et la même orientation que le cristal 1. Ses zones de compression 2, 3 d'ouverture angulaire $2\alpha$ sont ajustées avec serage sur la tranche du cristal, en respectant l'orientation par rapport à l'axe X du cristal défini de la manière indiquée plus haut par l'angle $\psi$ entre les bissectrices A–A des zones de compression 2, 3 et l'axe X. Le répartiteur de pression 5 présente des portions intermédiaires 4, 5 correspondant à des zones de non compression qui relient entre elles les zones de compression 2, 3. Ces parties intermédiaires 4, 5 sont radialement en retrait par rapport à la tranche du cristal de façon à n'exercer aucun effort sur le cristal. Les parties intermédiaires 4, 5 sont facilement réalisées à partir d'une bague circulaire pouvant présenter une section par exemple rectangulaire. Il suffit en effet de réaliser un dégagement dans la paroi interne de la bague au niveau des zones de non compression 4, 5.

Les figures 4 et 7, 8 concernent un second mode de réalisation dans lequel la compression radiale limitée est obtenue par la composante radiale d'une compression appliquée axialement au cristal-résonateur sur une zone circulaire et périphérique de sa convexité.

Dans ce cas, deux répartiteurs de pression 7, 8 sont placés symétriquement de part et d'autre du cristal-résonateur 1 et sont directement en contact avec lui par des zones de compression 21, 31; 22, 32 respectivement. Les répartiteurs de pression 7, 8 sont constitués par des bagues de quartz ayant la même coupe et la même orientation que le cristal de quartz 1. Les zones de non compression 40, 50 sont obtenues en réalisant des dégagement de faible profondeur tels que 41, 42 dans les faces des répartiteurs 7, 8 situées en regard du cristal 1, entre les zones de compression d'ouverture angulaire 2α.

Divers moyens de serrage, tels que des pinces ou des vis peuvent être utilisées pour exercer sur les répartiteurs 7, 8 un effort de serrage axial visant à créer indirectement une compression radiale limitée.

Comme on peut le constater, les répartiteurs de pression, 6, ou 7, 8 sont très faciles à associer à un cristal-résonateur 1 traditionnel, que ce dernier soit à électrodes adhérentes ou non. Dans le cas d'un cristal résonateur à électrodes non adhérentes portées par des disques situés de part et d'autre du cristal, les disques et le cristal définissent des couronnes périphériques qui sont en contact les unes avec les autres. Les répartiteurs de pression 6, ou 7, 8 peuvent agir sur la périphérie de l'ensemble cristal et disques supports d'électrodes comme s'il s'agissait d'un cristal-résonateur d'une seule pièce.

Dans tous les cas, le montage cristal 1, répartiteurs de pression 6 ou 7, 8 est compact, extrêmement rigide et à haute symétrie, tout en impliquant des opérations de montage et d'usinage simples.

Dans le cas d'un cristal-résonateur à électrodes adhérentes, le montage peut cependant être amélioré en réalisant, indépendamment de l'utilisation de répartiteurs de pression 6 ou 7, 8, des électrodes 10, 110 à dégagements qui définissent elles-mêmes des zones de compression ou d'extension (fig 13 et 14) d'une manière analogue à l'action des répartiteurs de pression décrits précédemment.

Le phénomène de compression ou d'extension est, cette fois, réalisé par les dilatations différentielles dues aux différences de caractéristiques entre le cristal de quartz et les électrodes en métal déposé.

C'est par une forme spéciale d'électrodes à dégagements, positionnées par rapport au repère cristallographique de quartz et situées sur chaque face du cristal, que s'exerce une compression (ou une traction) radiale uniformément répartie sur une zone limitée 2α et orientée ψ lorsque l'on fait varier la température.

La forme d'électrodes représentée sur la figure 13 avec des secteurs angulaires 12, 13 diamétralement opposés, s'étendant sur une ouverture 2α, présentant des bissectrices A'–A' formant un angle ψ avec l'axe cristallographique X du cristal, et séparés par des zones 14, 15 non métallisées, permet d'obtenir soit une compression radiale du cristal si l'électrode a un coefficient de dilatation plus faible que celui-ci, soit une extension radiale dans le cas contraire.

Si l'angle ψ est voisin de $\pi/2$ et si l'angle 2α est suffisamment important, pour un métal donné, il est possible de supprimer l'effet de la dilatation différentielle métal-quartz et de s'affranchir ainsi des variations de fréquences liées aux contraintes surfaciques pendant les variations de température.

## Revendications

1. Résonateur piézoélectrique à extremum de sensiblité vis à vis des contraintes extérieures de pression, comprenant un cristal piézoélectrique (1) constitué par une plaquette circulaire présentant au moins une face sphérique (101, 102), des première et deuxième électrodes (10, 110) coopérant chacune avec une face (101, 102) du cristal (1) et des moyens de suspension de la partie vibrante du cristal (1) appliqués sur la périphérie de celui-ci, caractérisé en ce qu'il comprend des moyens (2, 3; 20, 30) pour exercer des efforts de compression ou de traction radiale délocalisée de façon uniformément répartie sur des zones du pourtour du cristal (1) diamétralement opposées présentant une ouverture angulaire 2α prédéterminée au moins égale à environ 110°, et situées de telle manière que les bissectrices (A–A) desdites zones de pourtour forment un angle ψ prédéterminé voisin de 0° ou de 90° par rapport au repère cristallographique X du cristal.

2. Résonateur selon la revendication 1, caractérisé en ce que lesdits moyens (2, 3) pour exercer des efforts sur des zones du pourtour du cristal (1) comprennent une bague circulaire (6) en un matériau piézoélectrique présentant la même coupe et la même orientation que le cristal vibrant (1), qui est ajustée et serrée radialement contre la tranche du cristal (1) dans des zones (2, 3) s'étendant selon des secteurs angulaires définis par lesdites zones du pourtour du cristal (1) diamétralement opposées, et ne ce que ladite bague circulaire (6) comprend des parties intermédiaires (4, 5) radialement en retrait par rapport à la tranche du cristal (1) qui sont situées entre lesdites zones de serrage radial (2, 3).

3. Résonateur selon la revendication 1, caractérisé en ce que lesdits moyens (20, 30) pour exercer des efforts sur des zones du pourtour du cristal (1) comprennent des première et deuxième bagues circulaires (7, 8) en un matériau piézoélectrique présentant la même coupe et la même orientation que le cristal vibrant (1), qui sont placées symétriquement de part et d'autre du cristal vibrant (1) sur des zones circulaires et périphériques des faces (101, 102) du cristal (1) et sont en contact avec le cristal (1) au niveau desdites zones de pourtour du cristal diamétralement opposées, en ce que lesdites bagues (7, 8) présentent des parties intermédiaires (40, 50) axialement en retrait par rapport aux faces (101, 102) du cristal (1) dans des zones intermédiaires entre lesdites zones de pourtour du cristal (1) et en ce que lesdites bagues (7, 8) sont ajustées et serrées axialement contre les faces (101, 102) du cristal (1) au niveau desdites zones de pourtour du cristal (1).

4. Résonateur selon l'une quelconque des revendications 1 à 3, caractérisé en ce qu'il comprend des première et deuxième électrodes (10, 110) adhérentes au cristal (1) sur la partie centrale des faces frontales (101, 102) de celui-ci et en ce que les électrodes (10, 110) s'étendent chacune sur deux zones angulaires (12, 13; 112, 113) diamétralement opposées présentant une ouverture

angulaire 2α prédéterminée au moins égale à environ 110° et situées de telle sorte que les bissectrices (A'–A') desdites zones angulaires forment un angle ψ prédéterminé voisin de 0° ou de 90° par rapport au repère cristallographique X du cristal.

5. Résonateur selon l'une quelconque des revendications 1 à 4, caractérisé en ce qu'il comprend un cristal de quartz (1) de coupe AT placé à température ambiante, en ce que les bissectrices (A–A) desdites zones de pourtour forment un angle ψ de 90° par rapport au repère cristallographique X du cristal et en ce que l'ouverture angulaire 2α prédéterminée desdites zones de pourtour est de l'ordre de 120°.

6. Résonateur selon l'une quelconque des revendications 1 à 4, caractérisé en ce qu'il comprend un cristal de quartz (1) de coupe AT placé à sa température d'inversion, en ce que les bissectrices (A–A) desdites zones de pourtour forment un angle ψ de 90° par rapport au repère cristallographique X du cristal et en ce que l'ouverture angulaire 2α prédéterminé desdites zones de pourtour est de 142°.

7. Résonateur selon l'une quelconque des revendications 1 à 4, caractérisé en ce qu'il comprend un cristal de quartz (1) de coupe AT placé à température ambiante, en ce que les bissectrices (A–A) desdites zones de pourtour forment un angle ψ de 0° par rapport au repère cristallographique X du cristal et en ce que l'ouverture angulaire 2α prédéterminée desdites zones de pourtour est de 114°.

## Patentansprüche

1. Piezoelektrischer Resonator mit äußerst hoher Empfindlichkeit gegenüber äußeren Druckbelastungen, mit einem Schwingquarz (1), der von einem kreisförmigen Plättchen mit wenigstens einer Kugelfläche (101, 102) gebildet wird, wobei die erste und die zweite Elektrode (10, 110) jeweils mit einer Fläche (101, 102) des Kristalls (1) und mit Halterungsteilen für den schwingenden Teil des Kristalls (1) zusammenwirken, die am Umfang desselben anliegen, dadurch gekennzeichnet, daß er Mittel (2, 3; 20, 30) zur Ausübung von gleichmäßig verteilten, radialen, entlokalisierten Druck- oder Zugbeanspruchungen auf einander diametral gegenüberliegende Umfangsbereiche des Kristalls (1) aufweist, die eine vorbestimmte Winkelöffnung 2α von wenigstens etwa 110° besitzen und derart angeordnet sind, daß die Symmetrielinien (A–A) der genannten Umfangsbereiche mit der kristallographischen Orientierung X des Kristalls einen vorbestimmten Winkel von etwa 0° oder 90° einschließen.

2. Resonatoren nach Anspruch 1, dadurch gekennzeichnet, daß die genannten Mittel (2, 3) zur Ausübung von Beanspruchungen auf Umfangsbereiche des Kristalls (1) einen kreisförmigen Ring (6) aus einem piezoelektrischen Werkstoff umfassen, der denselben Querschnitt und dieselbe Orientierung aufweist wie der schwingende Kristall (1) und radial gegen den Rand des Kristalls (1) in den Bereichen gerichtet und gepreßt ist, die sich entsprechend den von den vorgenannten einander diametral gegenüberliegenden Umfangsbereichen des Kristalls (1) definierten Winkelsektoren erstrecken, und daß der genannte kreisförmige Ring (6) im Verhältnis zum Rand des Kristalls (1) radial zurückliegende Zwischenzonen (4, 5) aufweist, die zwischen den genannten radialen Klemmbereichen (2, 3) liegen.

3. Resonator nach Anspruch 1, dadurch gekennzeichnet, daß die genannten Mittel (20, 30) zur Ausübung von Beanspruchungen auf Umfangsbereiche des Kristalls (1) erste und zweite kreisförmige Ringe (7, 8) aus einem piezoelektrischen Werkstoff umfassen, die denselben Querschnitt und dieselbe Orientierung aufweisen wie der schwingende Kristall (1), symmetrisch beiderseits des schwingenden Kristalls (1) in Ring- und Umfangsbereichen der Seitenflächen (101, 102) des Kristalls (1) angeordnet sind und mit dem Kristall (1) auf der Ebene der genannten einander diametral gegenüberliegenden Umfangsbereiche des Kristalls (1) in Berührung stehen; daß die genannten Ringe (7, 8) im Verhältnis zu den Seitenflächen (101, 102) des Kristalls (1) axial zurückliegende Zwischenzonen (40, 50) aufweisen, die in zwischen den Umfangsbereichen des Kristalls (1) liegenden Zwischenbereichen angeordnet sind; und daß die genannten Ringe (7, 8) auf der Ebene der genannten Umfangsbereiche des Kristalls (1) axial gegen die Seitenflächen (101, 102) des Kristalls (1) gerichtet und gepreßt sind.

4. Resonator nach einem der Ansprüche 1 bis 3, dadurch gekennzeichnet, daß er dem Kristall (1) auf dem mittleren Teil der Stirnflächen (101, 102) desselben anhaftende erste und zweite Elektroden (10, 110) umfaßt, und daß die Elektroden (10, 110) sich jeweils über zwei einander diametral gegenüberliegende Winkelbereiche (12, 13; 112, 113) erstrecken, die eine vorbestimmte Winkelöffnung 2α von wenigstens etwa 110° aufweisen und derart angeordnet sind, daß die Symmetrielinien (A'–A') der genannten Winkelbereiche mit der kristallographischen Orientierung X des Kristalls einen vorbestimmten Winkel von etwa 0° oder 90° einschließen.

5. Resonator nach einem der Ansprüche 1 bis 4, dadurch gekennzeichnet, daß er einen AT-Quarzkristall (1) bei Raumtemperatur umfaßt; daß die Symmetrielinien (A–A) der genannten Umfangsbereiche mit der kristallographischen Orientierung X des Kristalls einen Winkel von 90° einschließen; und daß die vorbestimmte Winkelöffnung 2α der genannten Umfangsbereiche etwa 120° beträgt.

6. Resonator nach einem der Ansprüche 1 bis 5, dadurch gekennzeichnet, daß er einen auf seiner Umkehrtemperatur liegenden AT-Quarzkristall (1) umfaßt; daß die Symmetrielinien (A–A) der genannten Umfangsbereiche mit der kristallographischen Orientierung X des Kristalls einen Winkel von 90° einschließen; und daß die vorbestimmte Winkelöffnung 2α der genannten Umfangbereiche 142° beträgt.

7. Resonator nach einem der Ansprüche 1 bis 4, dadurch gekennzeichnet, daß er einen AT-Quarzkristall (1) bei Raumtemperatur umfaßt; daß die Symmetrielinien (A–A) der genannten Umfangsbereiche mit der kristallographischen Orientierung X des Kristalls einen Winkel von 0° einschließen; und daß die vorbestimmte Winkelöffnung 2α der genannten Umfangsbereiche 114° beträgt.

**Claims**

1. Piezoelectric resonator with extremum sensitivity to external pressure stresses, including a piezoelectric crystal (1) consisting of a circular plate comprising at least one spherical face (101, 102) a first and second electrodes (10, 110) each cooperating with one face (101, 102) of the crystal (1) and means for holding the vibrating part of the crystal (1) applied to its periphery, caracterised in that it incluses means (2, 3; 20, 30) for exerting nonlocalized radial compressive or tensile forces uniformly distributed over diametrically opposed zones on the periphery of the crystal (1) covering a predetermined sector 2α of at least approximately 110°, and oriented so that the bisectors (A–A) of said peripheral zones form a predetermined angle ψ close to 0° or 90° with respect to the crystallographic X axis of the crystal.

2. Resonator as claimed in claim 1, wherein said means (2, 3) for exerting forces on the peripheral zones of the crystal (1) include a circular ring (6) made of piezoelectric material with the same cut and orientation as the vibrating crystal (1) itself, and which is adjusted and tightened radially against the edge of the vibrating crystal (1) in zones (2, 3) extending through sectors defined by said diametrically opposed peripheral zones of the crystal (1), and wherein said circular ring (6) includes intermediate parts (4, 5) radially recessed from the edge of the crystal (1) that are located between said zones (2, 3) of radial tightening.

3. Resonator as claimed in claim 1, wherein said means 20, 30 for exerting forces on the peripheral zones of the crystal (1) include first and second circular ring (7, 8) made of piezoelectric material having the same cut and orientation as the vibrating cristal (1) and which are placed symmetrically on either side of the vibrating crystal (1) pressing on circular and peripheral zones on the faces (101, 102) of the crystal (1) and which are in contact with the crystal (1) at the level of said diametrically opposed peripheral zones of the crystal, wherein said ring (7, 8) have intermediate parts (40, 50) axially recessed from the faces (101, 102) of the crystal (1) in intermediate zones between said peripheral zones of the crystal (1) and wherein said rings (7, 8) fit the form of the faces (101, 102) oft the crystal (1) and are tightened against the said faces at the level of said peripheral zones of the crystal (1).

4. Resonator according to any of claims 1 to 3 including first and second electrodes (10, 110) adhering to the crystal (1) on the center part of the front faces (101, 102) of the crystal and wherein said electrodes (10, 110) each extend over two diametrically opposed angular zones (12, 13; 112, 113) making a predetermined sector angle 2α of at least approximately 110° and being oriented so that the bisectors (A–A) of said sectors form a predetermined angle ψ close to 0° or 90° with respect to the crystallographic X axis of the crystal.

5. Resonator according to any of claims 1 to 4 wherein the piezoelectric crystal (1) is an AT-cut quartz crystal placed at room temperature, and the bisectors (A–A) of said peripheral zones form an angle ψ of 90° with respect to the crystallographic X axis of the crystal, and wherein said predetermined sector angle 2α of said peripheral zones is of the order 120°.

6. Resonator according to any of claims 1 to 4 including an AT-cut quartz crystal (1) placed at its frequency inversion temperature, wherein the bisectors (A–A) of said peripheral zones form an angle ψ of 90° with respect to the crystallographic axis X of the crystal, and wherein said predetermined sector angle of said peripheral zones is 142°.

7. Resonator according to any of claim 1 to 4 including an AT-cut quartz crystal (1) placed at room temperature, wherein the bisectors (A–A) of said peripheral zones form an angle ψ of 0° with respect to the crystallographic X axis of the crystal, and wherein said predetermined sector angle 2α of said peripheral zones is 114°.

Fig.2

Fig.1

Fig.3

Fig.4

Fig.5

Fig.6

Fig.7

Fig.8

Fig.9  Fig.10  Fig.11  Fig.12

Fig.13

Fig.14

Fig. 15

Fig. 16

Fig. 17